# EUROPEAN PATENT APPLICATION

(11) **EP 2 800 266 A1**
(43) Date of publication of application: **05.11.2014**
(21) Application number: 12862449.1
(22) Date of filing: 30.08.2012
(51) Int. Cl.: H02M 7/487, H01L 21/338, H01L 27/095, H01L 29/778, H01L 29/812

(54) **MULTILEVEL INVERTER DEVICE**

(30) Priority: 28.12.2011 JP 2011289419
(71) Applicant: Panasonic Corporation, Kadoma-shi, Osaka 571-8501 (JP)
(72) Inventor: KIDERA, Kazunori, Osaka 540-6207 (JP)
(74) Representative: Appelt, Christian W.
(86) International application number: PCT/JP2012/005467
(87) International publication number: WO 2013/099053

(57) **Abstract**

A multilevel inverter device comprises: a series circuit of a first switching element 21 and a second switching element 22 connected between a terminal at a high voltage side and a terminal at a low voltage side of a DC electric power supply 2; a series circuit of two capacitors 11 and 12, which is connected in parallel with the first switching element 21 and the second switching element 22, to generate an intermediate voltage of the DC electric power supply2; and a single bidirectional switching element 100 connected between a connection point P1 of the two capacitors 11 and 12 and a connection point P2 of the first switching element 21 and the second switching element 22; and wherein the bidirectional switching element 100 has a horizontal transistor structure using GaN/AlGaN.

## Description

### Technical Field

The present invention relates to a multilevel inverter device which converts DC electric power into AC electric power.

### Background Art

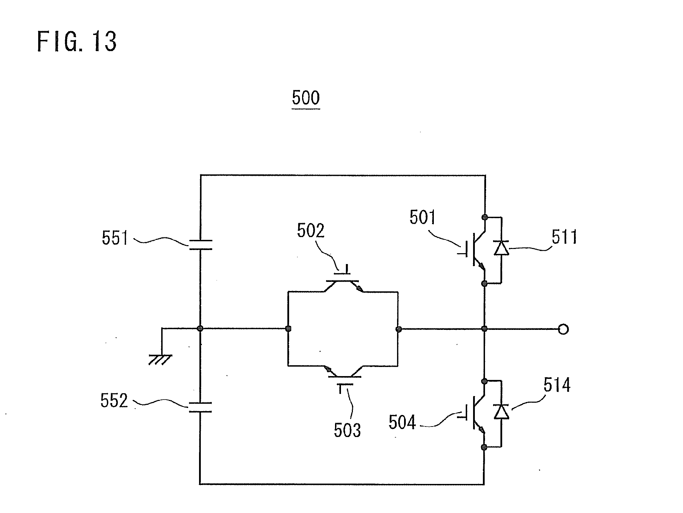

A multilevel inverter device has characteristics that a voltage waveform of an AC electric power outputted therefrom has few distortions, a low undesired sound and a low noise of electromagnetic waves. FIG. 13 shows a circuit of a multilevel inverter device of three levels generally used and shown in patent document 1, for example. As for this multi-level inverter device 500, two IGBTs (Insulated Gate Bipolar Transistor) 501 and 504 which are connected in series are connected to both ends of a series circuit of two capacitors 551 and 552 which serves as a DC electric power supply. In addition, diodes 511 and 514 are respectively connected to the IGBT 501 and 504 in reverse parallel connection. A connection point of the capacitors 551 and 552 is grounded, and a connection point of the IGBT 501 and 504 serves as an output terminal of an AC electric power. Two IGBTs 502 and 503 each having reverse breakdown voltage are connected in reverse parallel connection between the connection point of the capacitors 551 and 552 and the connection point of the IGBTs 502 and 503. In addition, as it is not illustrated, a DC electric power supply is connected between both ends of the series circuit of the capacitors 551 and 552. Moreover, a filtering circuit which is constituted of an inductor, a capacitor and so on is connected to the output terminal of the AC electric power.

When the IGBT 501 turns on and the IGBT 504 turns off, a positive voltage is outputted from the output terminal, when the IGBT 502 or 503 turns on and the IGBT 501 or 504 turns off, a voltage (0V) at an intermediate point is outputted from the output terminal; and when the IGBT 504 turns on and the IGBT 501 turns off, a negative voltage is outputted from the output terminal. Thereby, the AC electric power is outputted from the DC electric power supply.

As for the multilevel inverter device 500, by using the IGBTs as switching elements, it eliminates the need to connect diodes to the IGBTs 502 and 503 in series in comparison with a device using transistors as switching elements in particular, so that it enables to trim down a number of elements constituting an inverter circuit and to reduce electric power loss due to the elements.

In addition, patent document 2 discloses a multilevel inverter device which reduces electric power loss due to diodes by using diodes of wide-bandgap semiconductor as the diodes constituting an inverter circuit.

### Prior Art Document

### Patent Documents

Patent Document 1: Japanese Unexamined Patent Application Publication No. 2007-28860
Patent Document 2: Japanese Unexamined Patent Application Publication No. 2011-78296

### Disclosure of the Invention

The conventional multilevel inverter devices disclosed in the patent document 1 and the patent document 2 mentioned above respectively use two switching elements connected in reverse parallel connection in order to output the voltage (0V) at the intermediate point, so that it needs four switching elements in case of a single-phase alternating current multilevel inverter device of three levels, for example. Since a large electric current similar to an output current from the inverter flows to these switching elements and so on, the switching elements heat up. In addition, there is much heat value because there is a large number of elements to which large electric current flows. Therefore, efficiency of the multilevel inverter device deteriorates due to electric power loss by heating, and miniaturization of the multilevel inverter device is difficult because it needs heat radiation elements such as heat sinks.

The present invention is conceived to solve the problems of the above mentioned prior arts, and aimed to provide a multilevel inverter device which enables reduction of a number of elements, high efficiency due to low electric power loss and miniaturization due to trimming down of a number of heat radiation elements.

In order to achieve the above mentioned aims, a multilevel inverter device in accordance with an aspect of the present invention comprises: a series circuit of a first switching element and a second switching element connected between a terminal at a high voltage side and a terminal at a low voltage side of a DC electric power supply; a series circuit of two capacitors, which is connected in parallel with the first switching element and the second switching element, to generate an intermediate voltage of the DC electric power supply; a single bidirectional switching element connected between a connection point of the two capacitors and a connection point of the first switching element and the second switching element; and a control unit to output gate driving signals to the first switching element, the second switching element and the bidirectional switching element, and wherein the bidirectional switching element has a horizontal transistor structure using GaN/AlGaN.

It is preferable that the bidirectional switching element is constituted with a GaN layer and an AlGaN layer laminated on the GaN layer, and two drain electrodes and a gate electrode positioned between the two drain electrodes are formed on a surface of the AlGaN layer.

It is preferable that as for the bidirectional switching element, two gate electrodes are formed between the two drain electrodes, a portion between the two drain electrodes becomes conductive when gate driving signals are inputted to respective of the two gate electrodes, the portion between the two drain electrodes becomes non-conductive when no gate driving signals are inputted to the two gate electrodes, and it serves as a diode when a gate driving signal is inputted to only one of the two gate electrodes.

It is preferable that the control unit provides dead off times, during which the first switching element, the second switching element and the bidirectional switching element turn off, among gate driving signals to be outputted to the bidirectional switching element and gate driving signals to be outputted to the first switching element or the second switching element, and at least during the dead off times, a gate driving signal is inputted to only one of the two gates electrodes of the bidirectional switching element so as to operate the bidirectional switching element as a diode.

Hereupon, when calling the above mentioned bidirectional switching element as a first bidirectional switching element, it is preferable further to comprise a series circuit of a third switching element and a fourth switching element, which is connected in parallel with the series circuit of the first switching element and the second switching element, and a single second bidirectional switching element having substantially the same constitution as that of the first bidirectional switching element and connected between the connection point of the two capacitors and a connection point of the third switching element and the fourth switching element, and wherein the control unit outputs gate driving signals to the third switching element, the fourth switching element and the second bidirectional switching element, and when calling the first switching element, the second switching element and the first bidirectional switching element as a first switching element unit and the third switching element, the fourth switching element and the second bidirectional switching element as a second switching element unit, a difference between an output from the first switching element unit and an output from the second switching element unit is outputted as an AC electric power.

It is preferable that the first switching element, the second switching element and the first bidirectional switching element constitute a first switching element unit and the third switching element, the fourth switching element and the second bidirectional switching element constitute a second switching element unit, and the control unit switches the second switching element unit at a frequency higher than that of the first switching element unit, and drives the first switching element unit and the second switching element unit in a manner so that phases of them are inverted.

It is preferable that the third or the fourth switching element is constituted with a GaN layer and an AlGaN layer laminated on the GaN layer, and two drain electrodes and a gate electrode positioned between the two drain electrodes are formed on a surface of the AlGaN layer.

It is preferable that as for the third or the fourth switching element, two gate electrodes are formed between the two drain electrodes, and a portion between the two drain electrodes becomes conductive when gate driving signals are inputted to respective of the two gate electrodes, the portion between the two drain electrodes becomes non-conductive when no gate driving signals are inputted to the two gate electrodes, and serving as a diode when a gate driving signal is inputted to only one of the two gate electrodes.

It is preferable that the control unit provides a dead off time, during which the third switching element, the fourth switching element and the first bidirectional switching element turn off, among gate driving signals to be outputted to the second bidirectional switching element and gate driving signals to be outputted to the third switching element or the fourth switching element, and at least during the dead off time, a gate driving signal is inputted to only one of the two gates electrodes of the second bidirectional switching element so as to operate the bidirectional switching element as a diode.

According to the present invention, a number of switching elements is reduced by using the bidirectional switching element as one of the switching elements which constitute the multilevel inverter device, and as for the bidirectional switching element, a device having a horizontal transistor structure using GaN/AlGaN which is characterized by low electric power loss is used. Therefore, it enables the reduction of heating value due to trimming down a number of the switching elements and resulting promotion of high efficiency, and miniaturization of the multilevel inverter device due to reduction or miniaturization of the heat radiation elements.

### Brief description of the Drawings

[FIG. 1] FIG. 1 is a circuit diagram showing a constitution of a multilevel inverter device in accordance with a first embodiment of the present invention.
[FIG. 2] FIG. 2 is a plain view showing a constitution (a single gate type) of a bidirectional switching element use in the multilevel inverter device of the present invention.
[FIG. 3] FIG. 3 is an A-A cross section in FIG. 2.
[FIG. 4] FIG. 4 is a plain view showing another constitution (a dual gate type) of a bidirectional switching element used in the multilevel inverter device of the present invention.
[FIG. 5] FIG. 5 is an A-A cross section in FIG. 4.
[FIG. 6] FIG. 6 is a chart showing a characteristic of the bidirectional switching element shown in FIG. 4.
[FIG. 7] FIG. 7 is a waveform chart showing a basic motion of the multilevel inverter device in the first embodiment.
[FIG. 8] FIG. 8 is a waveform chart showing a concrete driving method to bring a voltage waveform outputted from an AC output terminal of the multilevel inverter device close to a sinusoidal wave more.
[FIG. 9] FIG. 9 is a waveform chart showing a concrete driving method of the multilevel inverter device in the first embodiment.
[FIG. 10] FIG. 10 is a waveform chart showing another concrete driving method of the multilevel inverter device in the first embodiment.
[FIG. 11] FIG. 11 is a circuit diagram showing a constitution of a multilevel inverter device in accordance with a second embodiment of the present invention.
[FIG. 12] FIG. 12 is a waveform chart showing a concrete movement of the multilevel inverter device in the second embodiment.
[FIG. 13] FIG. 13 is a circuit diagram showing a configuration of a conventional multilevel inverter device of three levels.

### Mode for Carrying Out the Invention

### (First Embodiment)

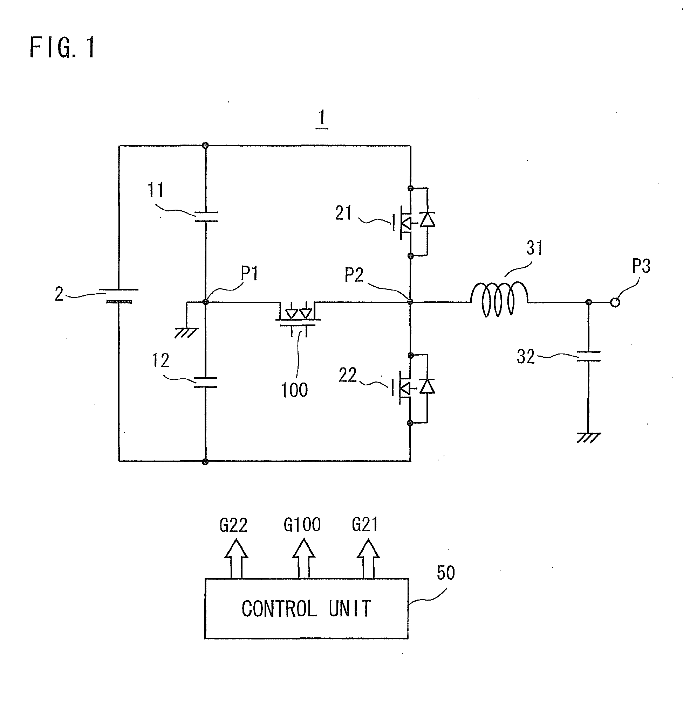

A multilevel inverter device in accordance with a first embodiment of the present invention is described. FIG. 1 shows a circuitry of the multilevel inverter device 1 of three levels in accordance with the first embodiment. As for this multilevel inverter device 1, a series circuit of a first switching element 21 and a second switching element 22 is connected between a terminal at high voltage side and a terminal at a low voltage side of a DC electric power supply 2. In addition, a series circuit of two capacitors 11 and 12 is connected in parallel with the series circuit of the first switching element 21 and the second switching element 22. From a connection point of these capacitors 11 and 12 connected in series, an intermediate voltage of the DC electric power supply 2 is generated. As for the first switching element 21 and the second switching element 22, FETs (Field Effect Transistor) or IGBT are used, for example. In addition, a single bidirectional switching element 100 is connected between a connection point P1 of the capacitors 11 and 12 and a connection point P2 of the first switching elements 21 and the second switching element 22. A filtering circuit configured with an inductor 31, a capacitor 32 and so on is connected to the connection point P2 of the first switching element 21 and the second switching element 22, so that an AC electric power is output from this filtering circuit. A control unit 50 outputs gate driving signals G21, G22 and G100 to each switching elements 21, 22 and 100.

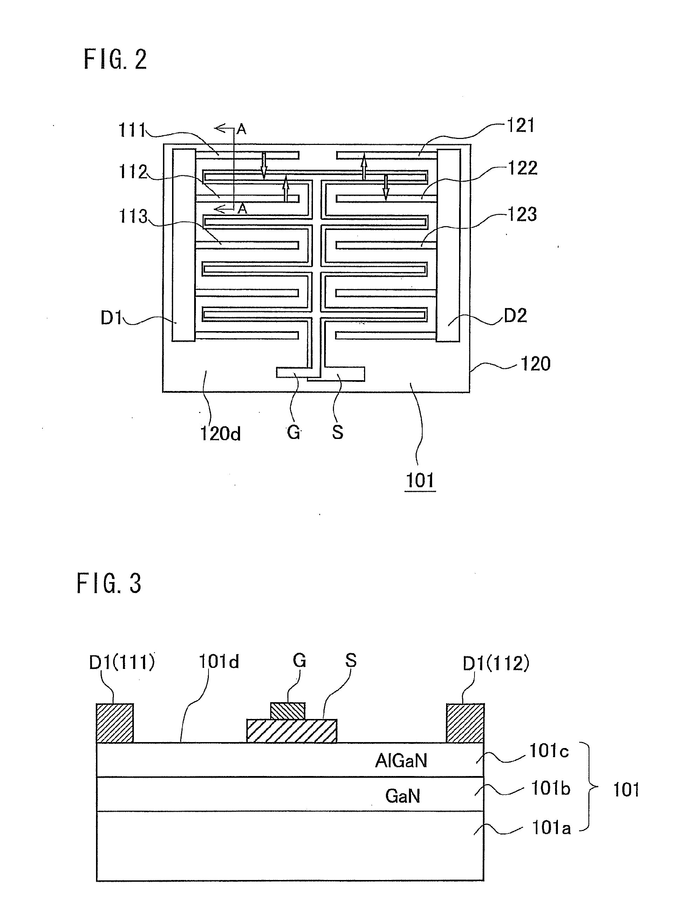

Subsequently, a concrete structure of the bidirectional switching element 100 is described. The bidirectional switching element 100 is a bidirectional switching element having a horizontal transistor structure using GaN/AlGaN. FIG. 2 is a plain view showing an example of constitution of the bidirectional switching element 100, and FIG. 3 is an A-A cross section. In addition, this bidirectional switching element 100 is called a single gate type because only one gate G is provided between two electrodes D1 and D2.

As shown in FIG. 3, a substrate 101 of the bidirectional switching element 100 is configured with a conductor layer 101a, a GaN layer 2b laminated on the conductive layer 101a, and an AlGaN layer 010c further laminated on the GaN layer 2b. In this embodiment, the two-dimensional electron gas layer occurring in an AlGaN/GaN heterointerface is utilized as a channel layer. As shown in FIG. 2, a first electrode D1, a second electrode D2 and an intermediate electric potential region S which has an intermediate electric potential with respect to an electric potential of the first electrode D1 and an electric potential of the second electrode D2 are formed on a surface 101d of the substrate 101. In addition, a control electrode (gate) G is laminated on the intermediate electric potential region S. As the control electrode G, a Schottky electrode is used, for example. The first electrode D1 and the second electrode D2 respectively have a comb shape with a plurality of electrode regions 111, 112, 113... and 121, 122, 123... which are arranged in parallel with each other, and the electrode regions arranged in the comb shape are disposed to face each other. The intermediate electric potential region S and the control electrode G are disposed between the electrode regions 111, 112, 113... and 121, 122, 123... which are arranged in the comb shape, and have a shape similar to a plane shape (substantially herringbone shape) of a space formed between the electrode regions.

As shown in FIG. 2, the electrode region 111 of the first electrode D1 and the electrode region 121 of the second electrode D2 are arranged in a manner so that centerlines of them in width directions are located on the same line. In addition, the intermediate electric potential region S and the control electrode G are respectively provided in parallel with the arrangements of the electrode region 111 of the first electrode D1 and the electrode region 121 of the second electrode D2. Distances from the electrode region 111 of the first electrode D1 and the electrode region 121 of the second electrode D2 to the intermediate electric potential region S and the control electrode G in the above width direction are set to be a distance by which predetermined breakdown voltage can be maintained. The same applies to those in a direction perpendicular to the above width direction, that is, longitudinal directions of the electrode region 111 of the first electrode D1 and the electrode region 121 of the second electrode D2. In addition, these relations can apply to other electrode regions 112 and 122, 113 and 123... In other words, the intermediate electric potential part S and the control electrode G are located at positions by which predetermined breakdown voltage for the first electrode D1 and the second electrode D2 can be maintained. Therefore, even though the first electrode D1 is at a higher potential side and the second electrode D2 is at the lower potential side, when the bidirectional switching element 100 is in a turn-off state, an electric current is surely intercepted at least in a region between the first electrode D1 and the control electrode G and the intermediate electric potential region S (the electric current is interrupted a region just below the control electrode (gate) G). On the other hand, when the bidirectional switching element 100 is in turn-on state, that is, when a signal having a voltage higher than a predetermined threshold value is applied to the control electrode G, an electric current flows along a path from the first electrode D1 (the electrode regions 111...), to the second electrode D12 (the electrode regions 121...) through the intermediate electric potential region S, as shown by arrows in the figure, and vice versa. Consequently, even when the threshold voltage of the signal applied to the control electrode G is decreased to the minimum level, it is possible to turn on/off the bidirectional switching element 100 surely, and thus, it is possible to realize a low on-resistance. In addition, since the electrode regions 111, 112, 113... of the first electrode D1 and the electrode regions 121, 122, 123... of the second electrode D2 can be arranged in the comb shape, it is possible to obtain a large electric current without upsizing a tip size of the bidirectional switching element 100.

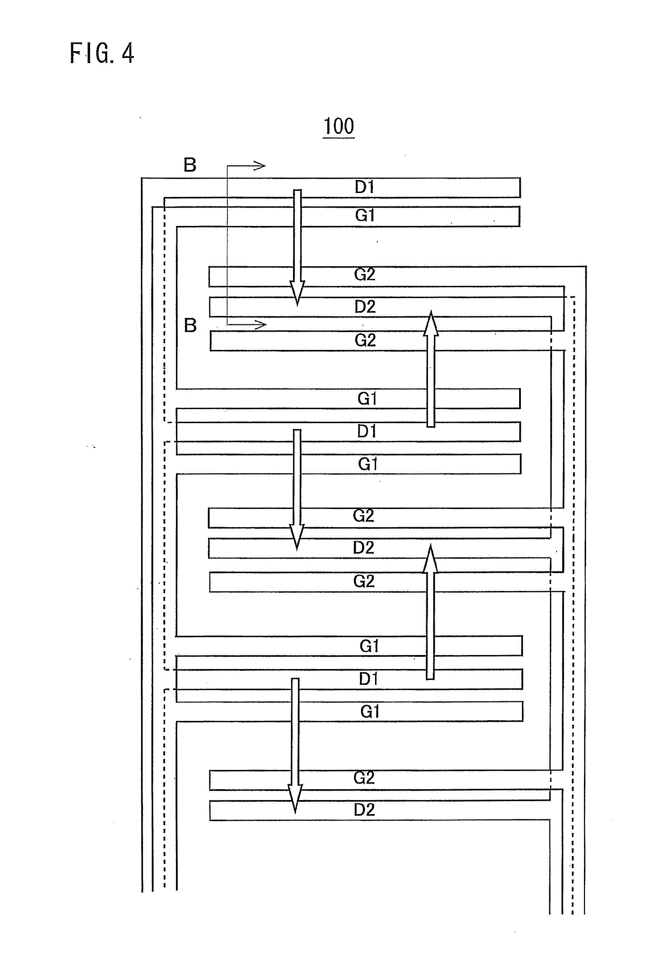

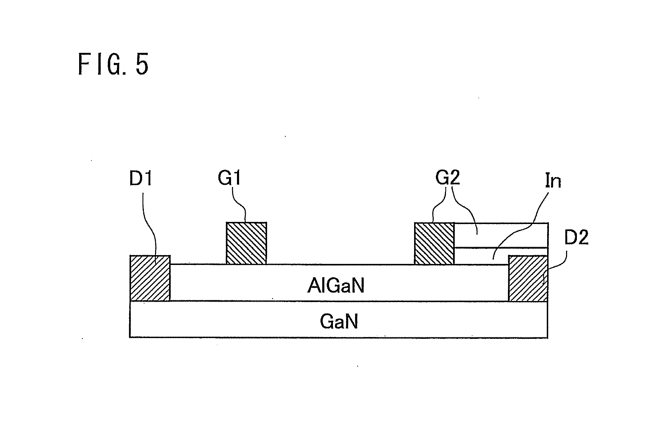

FIGS. 4 and 5 show another constitution example of the bidirectional switching element 100. FIG. 4 is a plain view showing a constitution of the bidirectional switching element 100, and FIG. 5 is a B-B cross section. In addition, this bidirectional switching element 100 is called dual gate type because two gates G1 and G2 are formed between two electrodes D1 and D2.

As shown in FIGS. 4 and 5, the bidirectional switching element 100 of horizontal dual gate transistor structure is a structure to realize a bidirectional element of low electric power loss having only one place to be maintained the breakthrough voltage. In other words, drain electrodes D1 and D2 are formed to reach a GaN layer each, and gate electrodes G1 and G2 are formed on an AlGaN layer each. Under a state that no voltage is applied to the gate electrodes G1 and G2, a vacant zone of electrons occurs in a two-dimensional electron gas layer occurring in the AlGaN/GaN heterointerface just below the gate electrodes G1 and G2, so that no electric current flows. On the other hand, when a voltage is applied to the gate electrodes G1 and G2, an electric current flows in the AlGaN/GaN heterointerface from the drain electrode D1 to the drain electrode D2 (in vice versa). Although a region between the gate electrodes G1 and G2 needs breakdown voltage and to be provided a constant distance, a region between the drain electrode D1 and the gate electrode G1 and a region between the drain electrode D2 and the gate electrode G2 need no breakdown voltage. Therefore, the drain electrode D1 and the gate electrode G1, and the drain electrode D2 and the gate electrode G2 may be overlapped via an insulation layer In. In addition, an element of this constitution has to be controlled on the basis of the voltages of the drain electrode D1 and D2, so that it is necessary to input drive signals into two gate electrodes G1 and G2 each (therefore it is called dual gate transistor structure).

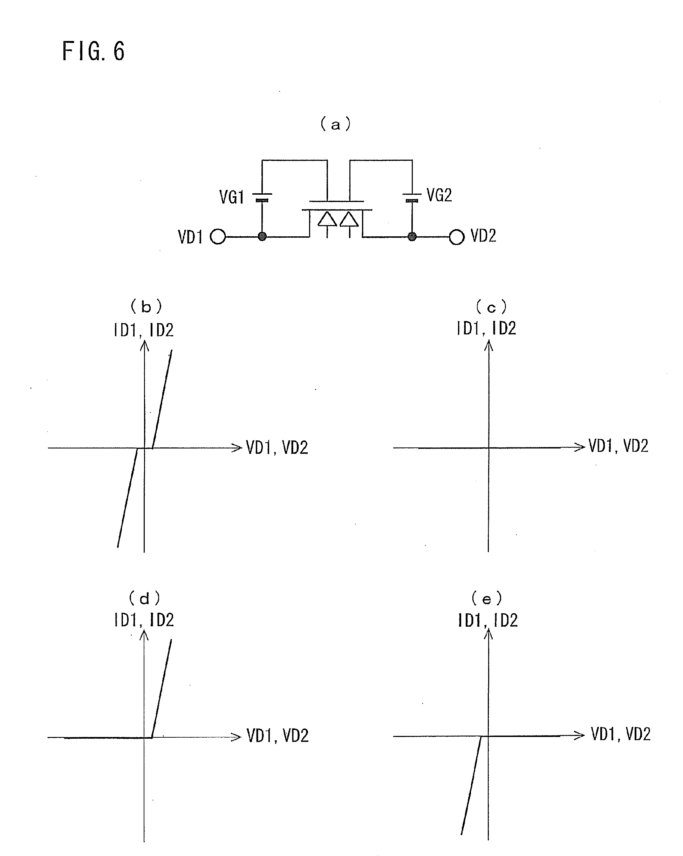

FIG. 6 shows a characteristic of this dual gate type bidirectional switching element 100. FIG. 6(a) shows an equivalent circuit of the dual gate type bidirectional switching element 100, since this element is dual gate type, there are two gates used to switching control, and thus, there are threshold values for on and off, respectively. The threshold values are respectively substantially the same values for the two gates, and since it is normally-off type one, the element turns on when voltages of the gates are higher than the threshold values (positive values). Hereupon, since there are four ways among combinations of states of the two gates, I-V characteristics of respective cases are shown in FIGS. 6(b)-(e). In FIGS. 6(b)-(e), VD1 and VD2 respectively designate voltages of the drain electrodes D 1 and D2 in FIG. 5, and VG1 and VG2 respectively designate voltages of the gate driving signals applied to the gate electrodes G1 and G2. In addition, ID1 and ID2 respectively designate electric currents flowing between the gate electrodes G1 and G2. FIG. 6(b) shows a first state that voltages of the gate driving signals G21 and G22 are higher than the thresholds and both of the gates D1 and D2 are on states, so that the bidirectional switching element 100 becomes turn-on state. FIG. 6(c) shows a second state that the voltages of the gate driving signals G21 and G22 are lower than the thresholds and both of the gates D1 and D2 are off states, so that the bidirectional switching element 100 becomes turn-off state. FIG. 6(d) shows a third state that the voltage of the gate driving signal G21 is higher than the threshold, the voltage of the gate driving signal G22 is lower than the threshold, the gate D1 is on state and the gate D2 is off state, so that the bidirectional switching element 100 enables to flow an electric current only in one direction like a diode. FIG. 6(e) shows a fourth state that the voltage of the gate driving signal G22 is higher than the threshold, the voltage of the gate driving signal G21 is lower than the threshold, the gate D2 is on state and the gate D1 is off state, so that the bidirectional switching element 100 enables to flow an electric current only in one direction opposite to that in the case of FIG. 6(d).

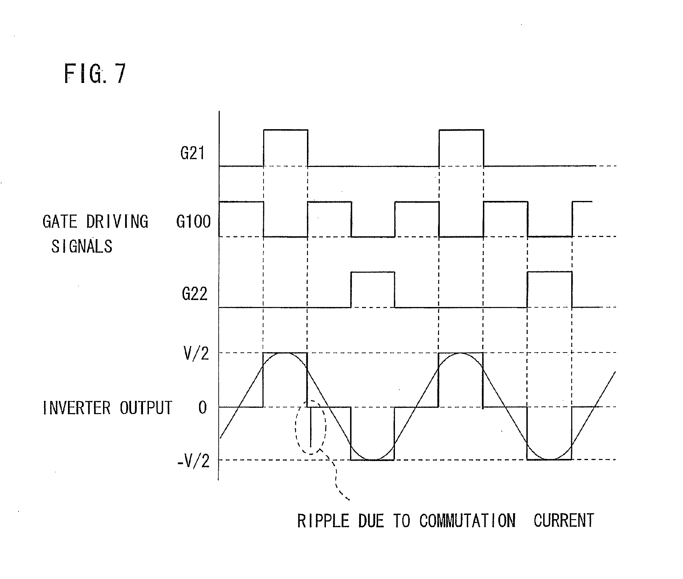

Subsequently, a basic motion of the multilevel inverter device 1 in the first embodiment is described. FIG. 7 shows waveforms of the gate driving signals G21, G22 and G100 outputted from the control unit 100, a waveform of a voltage at the connection point P2 of the multilevel inverter device 1 and a waveform of a voltage at the AC output terminal P3 (these are called inverter outputs, generically). In this case, as the bidirectional switching element 100, it may be anyone of the above mentioned single gate type one or the dual gate type one. In the case of the dual gate type one, it is assumed that the same gate driving signals are inputted into the two gates D1 and D2 simultaneously.

As shown in FIG. 7, when it is assumed that only the gate driving signal G100 is outputted at first and an output voltage of the DC electric power supply is designated by a symbol V, the voltage at the connection point P2 becomes an intermediate voltage 0 (V). Subsequently, when outputting of the gate driving signal G100 is suspended and outputting of the gate driving signals G21 is recommenced, the first switching element 21 turns on and the second switching element 22 turns off, so that an electric current flows from the DC electric power supply 2 to the inductor 31 through the first switching element 21. Therefore, the voltage at the connection point P2 becomes a voltage V/2 which a half of the output voltage of the DC electric power supply 2. Furthermore, when outputting of the gate driving signal G21 is suspended and outputting of the gate driving signal G100 is recommenced, the first switching element 21 and the second switching element 22 turn off and the bidirectional switching element 100 turns on, so that the voltage at the connection point P2 becomes the intermediate voltage 0, again. Still furthermore, when outputting of the gate driving signal G100 is suspended and outputting of the gate driving signal G22 is recommenced, the first switching element 21 turns off and the second switching element 22 turns on, so that the voltage at the connection point P2 becomes a voltage -V/2. Still furthermore, when outputting of the gate driving signal G22 is suspended and outputting of the gate driving signal G100 is recommenced, the voltage at the connection point P2 becomes the intermediate voltage 0, again. By performing such operations repeatedly, the voltage at the connection point P2 of the multilevel inverter device 1 varies like 0, V/2, 0, -V/2, 0, V/2, 0, -V/2 ... In addition, an AC electric power which is smoothed these rectangular waves is outputted from the AC output terminal 3 of the multilevel inverter device 1.

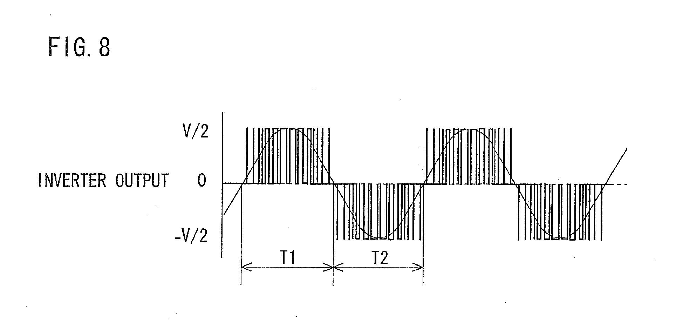

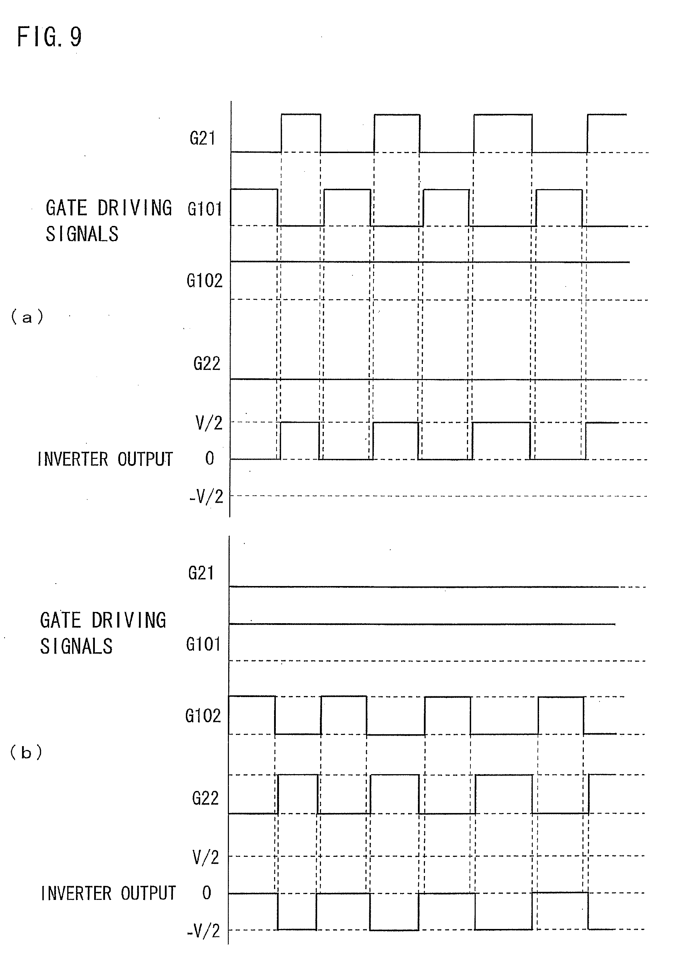

By the way, in order to make a voltage waveform outputted from the AC electric output terminal P3 of the multilevel inverter device 1 be much closer to a sinusoidal wave, switching of the gate driving signals G21, G22 and G100 are performed multiple times during 1/2 period of one cycle of the AC electric power, for example, as shown in FIG. 8. On the other hand, in the inverter device, a short circuit electric current may flow when a plurality of the switching elements turns on simultaneously. Therefore, dead off times, during which all the switching elements turn off temporarily, are provided. FIG. 9(a) shows waveforms of the gate driving signals and the inverter output in a period T1 during which the inverter output shows a positive voltage in FIG. 8. In addition, FIG. 9(b) shows waveforms the gate driving signals and the inverter output in a period T2 during which the inverter output shows a negative voltage in FIG. 8. In this case, as the bidirectional switching element 100, a dual gate type one is used, and thus, it is assumed to call the gate driving signals to be inputted into the two gates D1 and D2 as G101 and G102, respectively.

As shown in FIG. 9(a), the voltage of the gate driving signal G22 is always under the threshold (in other words, the gate driving signal G22 is not outputted) in the period T1 during which the inverter output shows the positive voltage, and thus, the second switching element 22 turns off. In addition, the voltage of the gate driving signal G102 is always above the threshold; (in other words, the gate driving signal G102 is continuously outputted). The voltage of the gate driving signal G101 repeats a state of above the threshold and a state of under the threshold alternately (in other words, the gate driving signal G101 repeats an outputted state and a non-outputted state of predetermined time periods). When both of the voltages of the gate driving signal G101 and G102 are above the thresholds, the bidirectional switching element 100 turns on. In addition, the voltage of the gate driving signal G21 becomes above the threshold after the voltage of the gate driving signal G101 becomes under the threshold and further passing a predetermined dead off time, and becomes above the threshold after the voltage of the gate driving signal G21 becomes under the threshold and further passing a predetermined dead off time (in other words, the gate driving signal G21 is outputted while the gate driving signal G101 is non-outputted state).

On the other hand, as shown in FIG. 9(b), in the period T2 during which the inverter output shows a negative voltage, the voltage of the gate driving signal 21 is always under the threshold, and thus, the switching element 21 turns off. In addition, the voltage of the gate driving signal G101 is always above the threshold. The voltage of the gate driving signal G102 repeats a state of above the threshold and a state of under the threshold alternately, and when both of the voltages of the gate driving signal G101 and G102 is above the thresholds, the bidirectional switching element 100 turns on. The voltage of the gate driving signal G22 becomes above the threshold after the voltage of the gate driving signal G102 becomes under the threshold and further passing a predetermined dead off time. In addition, the voltage of the gate driving signal G102 becomes above the threshold after the voltage of the gate driving signal G22 becomes under the threshold and further passing a predetermined dead off time.

In FIGS. 9(a) and (b), pulse widths of the gate driving signals G21 and G22 are varied. In other words, on the basis of a zero-cross point of the AC electric power outputted from the AC output terminal P3 of the multilevel inverter device 1, initially, the pulse width of the gate driving signal G21 is made narrower, the pulse width is gradually made wider, and the pulse width is made maximum near to 1/4 of one cycle of the AC electric power, subsequently, the pulse width is made gradually narrower. By adopting such a driving method, the voltage waveform outputted from the AC output terminal 3 of the multilevel inverter device 1 can bring much closer to a sinusoidal wave.

In the multilevel inverter circuit shown in FIG. 1, when the first switching element 21 changes from the turn-on state to the turn-off state, the electric power stored in the inductor 31 and the capacitor 32 which constitute the filtering circuit goes to flow through a parasitism diode of the second switching element 22 via the capacitor 12 (a commutating current). Then, such a commutating current goes to flow until the bidirectional switching element 100 turns on. Since the commutating current flows from a low voltage side, a ripple appears in the voltage waveform outputted from the AC output terminal P3, as shown by an oval of a dashed line in FIG. 7. In addition, when reverse recovery time of the parasitism diode of the second switching element 22 is longer, a short circuit phenomenon of the bidirectional switching element 100 and the parasitism diode of the second switching element 22 occurs, and thus, a problem of a large switching loss arises. In particular, as for the FET with a few electric power loss in turn-on state, reverse recovery of a parasitism diode tends to be late, so that a relation of a trade-off comes into existence between the electric power loss in the turn-on state and the switching loss.

However, as shown in FIGS. 9(a) and (b), the gate driving signal G101 or G102 is always inputted into one of the gate electrodes D1 or D2 of the bidirectional switching element 100. In other words, as shown in FIG 6(d) or (e), the bidirectional switching element 100 serves as a diode. Therefore, when the first switching element 21 changes from the turn-on state to the turn-off state, an electric current flows the bidirectional switching element 100 serving as a diode and does not flow to the parasitism diode of the second switching element 22. Consequently, no ripple due to the commutation current to the parasitism diode of the second switching element 22 occurs, and thus, no switching loss due to delay of reverse recovery of the parasitism diode of the second switching element 22 occurs, too.

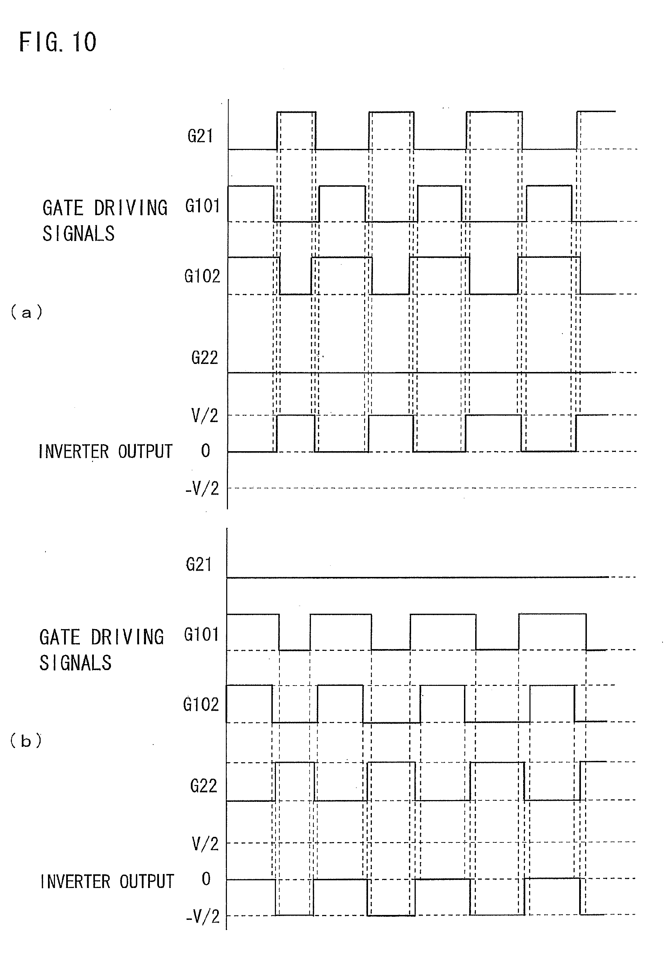

FIGS. 10 (a) and (b) show another driving example of the multilevel inverter device 1. Although the voltage of the gate driving signal G101 or G 102 is always made to be above the threshold in the driving example shown in FIGS. 9(a) and (b), it is sufficient that the bidirectional switching element 100 serves as a diode at least in the dead off time and it is no need to make the voltage of the gate driving signal G101 or G 102 always be above the threshold in other time periods. Then, in the driving example shown in FIGS. 10(a) and (b), it is configured that the voltage of the gate driving signal G101 or G 102 is made to be above the threshold just before changing the first switching element 21 or the second switching element 22 from the turn-on state to the turn-off state and from the turn-off state to the turn-on state. By such a driving method, it is possible to reduce electric power consumption due to the gate driving signals and to promote efficiency of the multilevel inverter device 1 higher.

### (Second Embodiment)

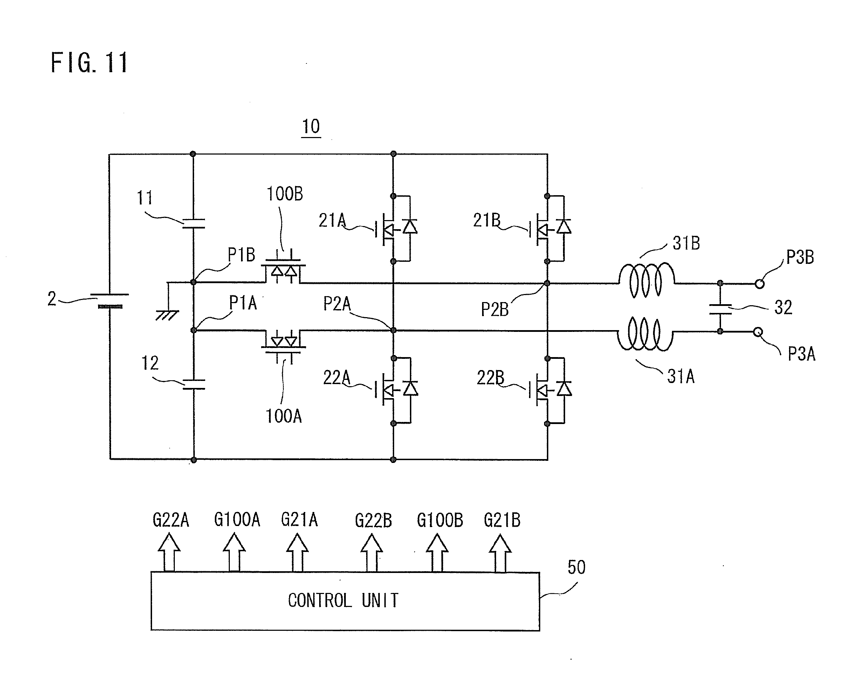

A multilevel inverter device in accordance with a second embodiment of the present invention is described. FIG. 11 shows a circuitry of a multilevel inverter device 10 of five levels in accordance with the second embodiment. As for this multilevel inverter device 10, a series circuit of two capacitors 11 and 12 is connected between a terminal at a high voltage side and a terminal at a low voltage side of a DC electric power supply 2, and two sets of a series circuit of a first switching element 21A and a second switching element 22A and a series circuit of a third switching element 21B and a fourth switching element 22B are connected in parallel with the series circuit of the capacitors 11 and 12. As these switching elements 21A, 22A, 21B, 22B, FETs or IGBTs are used, for example. In addition, a first bidirectional switching element 100A is connected between a connection point P1A of the capacitors 11 and 12 and a connection point P2A of the first switching element 21A and the second switching element 22A. Similarly, a second bidirectional switching element 100B is connected between a connection point P1B of the capacitors 11 and 12 and a connection point P2B of the third switching element 21B and the fourth switching element 22B. It is preferable that the first bidirectional switching element 100A and the second bidirectional switching element 100B have the same constitution, and they may be any of the single gate type one and the dual gate type one among the above mentioned bidirectional switching elements having the horizontal transistor structure using GaN/AlGaN.

An inductor 31 A is connected between a connection point P2A of the first switching element 21 and the second switching element 22 and an AC electric power output terminal 31A, and an inductor 31B is connected between a connection point P2B of the third switching element 21B and the fourth switching element 22B and an AC electric power output terminal 31B. Furthermore, a capacitor 32 is connected between the AC electric power output terminal 31A and the AC electric power output terminal 31B. AC electric power is outputted from the AC electric power output terminal 31A and the AC electric power output terminal 31B. A control unit 50 outputs gate driving signals G21A, G22A, G21B, G22B, G100A, G100B to the switching elements 21A, 22A, 21B, 22B, 100A and 100B. The multilevel inverter device 10 in accordance with the second embodiment has two sets of switching element units and outputs a difference between outputs of the two sets of the switching element units as an AC electric power.

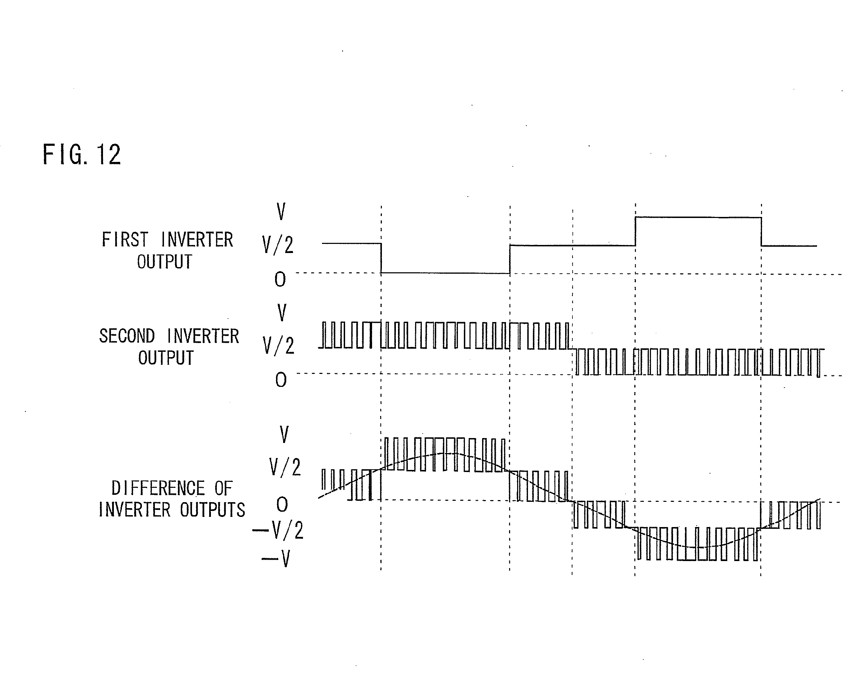

The first switching element 21 A, the second switching element 22A and the first bidirectional switching element 100A constitute a first switching element unit, and an output therefrom is called a first inverter output. In addition, the third switching element 21B, the fourth switching element 22B and the second bidirectional switching element 100B constitute a second switching element unit, and an output therefrom is called a second inverter output. FIG. 12 shows the first inverter output, the second inverter output and a difference of them. The first switching element unit and the second switching element unit are respectively three level inverters in which the output voltage is varied among V/2, 0 and -V/2. Therefore, the difference between the first inverter output of the first switching element unit and the second inverter output of the second switching element unit constitutes a five level inverter in which the output voltage varies among V, V/2, 0, -V/2 and -V. As can be seen from FIG. 12, the control unit 50 performs switching of the first switching element unit at a low frequency (low speed) and performs switching of the second switching element unit at a high frequency (high speed). In addition, the control unit 50 operates the first switching element unit and the second switching element unit in a manner so that phases of them are inverted. Therefore, the difference between the first inverter output and the second inverter output outputted from the connection points P2A and P2B becomes a waveform to which the switching is performed at a high speed. When smoothing is performed to this difference output by a filtering circuit configured of the inductors 31A and 31B and the capacitor 32, a waveform of the AC electric power outputted from the AC electric power output terminals 31A and 31B becomes substantially a sinusoidal wave.

It is assumed that the voltage of the AC electric power outputted from the multilevel inverter device 10 of five levels of the second embodiment is the same as that of the multilevel inverter device 1 of three levels described in the first embodiment, an amplitude of a waveform to be performed the smoothing in the multilevel inverter device 10 in the second embodiment becomes 1/2 in comparison with an amplitude of a waveform in the first embodiment. Therefore, a reactor loss in the smoothing in the multilevel inverter device 10 becomes few than a reactor loss in the smoothing in the multilevel inverter device 1. In addition, it goes without saying that driving method of each switching element of the first switching element unit and the second switching element unit is performed by the either method shown in the above FIG. 9 or FIG. 10.

As described above, according to the present invention, a single bidirectional switching element is used instead of two IGBTs which are connected in reverse parallel with each other conventionally in a multilevel inverter device, so that a number of switching elements can be trimmed down, and heating value and electric power loss due to the switching elements can be reduced. In addition, following to the reduction of heating value, miniaturization of the multilevel inverter device itself is enabled by trimming down or miniaturization of heat radiation elements such as heat sinks.

Furthermore, for the bidirectional switching element, a bidirectional switching element having a horizontal transistor structure using GaN/AlGaN is used, so that electric power loss due to the switching element itself can be made much fewer in comparison with a switching element having a vertical transistor structure such as a triac, for example. In other words, as for the bidirectional switching element having a horizontal transistor structure using GaN/AlGaN, an electric current flows along an interface of a GaN layer and an AlGaN layer, and thus, never flows through laminated semiconductor layers. Accordingly, heat or electric power loss of the bidirectional switching element itself having the horizontal transistor structure is much fewer than heat or electric power loss of the switching element having the vertical transistor structure.

This application is based on Japanese patent application 2011-289419 filed in Japan, the contents of which are hereby incorporated by reference of the description and drawings of the above mentioned patent application..

Although the present invention has been fully described by way of example with reference to the accompanying drawings, it is to be understood that various changes and modifications will be apparent to those skilled in the art. Therefore, unless otherwise such changes and modifications depart from the scope of the present invention, they should be construed as being included therein.

### [Explanation of symbols]

- 1, 10:: Multilevel inverter device
- 2 :: DC electric power supply
- 11, 12:: Capacitor
- 21, 21A:: First switching element
- 21B:: Third switching element
- 22, 22A:: Second switching element
- 22B:: Fourth switching element
- 31, 31A, 31B :: Inductor
- 32:: Capacitor
- 100:: Bidirectional switching element
- 100A:: First bidirectional switching element
- 100B:: Second bidirectional switching element

## Claims

1. A multilevel inverter device comprising:
a series circuit of a first switching element and a second switching element connected between a terminal at a high voltage side and a terminal at a low voltage side of a DC electric power supply;
a series circuit of two capacitors, which is connected in parallel with the first switching element and the second switching element, to generate a middle voltage of the DC electric power supply;
a single bidirectional switching element connected between a connection point of the two capacitors and a connection point of the first switching element and the second switching element; and
a control unit to output gate driving signals to the first switching element, the second switching element and the bidirectional switching element, and wherein
the bidirectional switching element has a horizontal transistor structure using GaN/AlGaN.

2. The multilevel inverter device in accordance with claim 1, wherein the bidirectional switching element is constituted with a GaN layer and an AlGaN layer laminated on the GaN layer, and two drain electrodes and a gate electrode positioned between the two drain electrodes are formed on a surface of the AlGaN layer.

3. The multilevel inverter device in accordance with claim 2, wherein
as for the bidirectional switching element,
two gate electrodes are formed between the two drain electrodes,
a portion between the two drain electrodes becomes conductive when gate driving signals are inputted to respective of the two gate electrodes,
the portion between the two drain electrodes becomes non-conductive when no gate driving signals are inputted to the two gate electrodes, and
it serves as a diode when a gate driving signal is inputted to only one of the two gate electrodes.

4. The multilevel inverter device in accordance with claim 3, wherein
the control unit provides dead off times, during which the first switching element, the second switching element and the bidirectional switching element turn off, among gate driving signals to be outputted to the bidirectional switching element and gate driving signals to be outputted to the first switching element or the second switching element, and at least during the dead off times, a gate driving signal is inputted to only one of the two gates electrodes of the bidirectional switching element so as to operate the bidirectional switching element as a diode.

5. The multilevel inverter device in accordance with claim 1, wherein
when calling the bidirectional switching element as a first bidirectional switching element;
the multilevel inverter device further comprises a series circuit of a third switching element and a fourth switching element, which is connected in parallel with the series circuit of the first switching element and the second switching element, and a single second bidirectional switching element having substantially the same constitution as that of the first bidirectional switching element and connected between the connection point of the two capacitors and a connection point of the third switching element and the fourth switching element, and wherein
the control unit outputs gate driving signals to the third switching element, the fourth switching element and the second bidirectional switching element, and
when calling the first switching element, the second switching element and the first bidirectional switching element as a first switching element unit and the third switching element, the fourth switching element and the second bidirectional switching element as a second switching element unit, a difference between an output from the first switching element unit and an output from the second switching element unit is outputted as an AC electric power.

6. The multilevel inverter device in accordance with claim 5, wherein
the first switching element, the second switching element and the first bidirectional switching element constitute a first switching element unit;
the third switching element, the fourth switching element and the second bidirectional switching element constitute a second switching element unit; and
the control unit performs switching the second switching element unit at a frequency higher than that of the first switching element unit, and operates the first switching element unit and the second switching element unit in a manner so that phases of them are inverted.

7. The multilevel inverter device in accordance with claim 5 or claim 6, wherein the third or the fourth switching element is constituted with a GaN layer and an AlGaN layer laminated on the GaN layer, and two drain electrodes and a gate electrode positioned between the two drain electrodes are formed on a surface of the AlGaN layer.

8. The multilevel inverter device in accordance with claim 7, wherein
as for the third or the fourth switching element,
two gate electrodes are formed between the two drain electrodes;
a portion between the two drain electrodes becomes conductive when gate driving signals are inputted to respective of the two gate electrodes,
the portion between the two drain electrodes becomes non-conductive when no gate driving signals are inputted to the two gate electrodes, and
it serves as a diode when a gate driving signal is inputted to only one of the two gate electrodes.

9. The multilevel inverter device in accordance with claim 8, wherein
the control unit provides dead off times, during which the third switching element, the fourth switching element and the first bidirectional switching element turn off, among gate driving signals to be outputted to the second bidirectional switching element and gate driving signals to be outputted to the third switching element or the fourth switching element, and at least during the dead off times, a gate driving signal is inputted to only one of the two gates electrodes of the second bidirectional switching element so as to operate the bidirectional switching element as a diode.
